Europäisches Patentamt

(19) European Patent Office

Office européen des brevets

(11) Veröffentlichungsnummer: **0 061 046**

A1

(12) # EUROPÄISCHE PATENTANMELDUNG

(21) Anmeldenummer: 82101783.7

(22) Anmeldetag: 06.03.82

(51) Int. Cl.³: **H 01 L 29/08**
**H 01 L 29/10, H 01 L 29/743**

(30) Priorität: 14.03.81 DE 3109892

(43) Veröffentlichungstag der Anmeldung:
29.09.82 Patentblatt 82/39

(84) Benannte Vertragsstaaten:
AT CH FR GB IT LI

(71) Anmelder: SEMIKRON, GESELLSCHAFT FÜR
GLEICHRICHTERBAU UND ELEKTRONIK M.B.H.
Sigmundstrasse 200
D-8500 Nürnberg(DE)

(72) Erfinder: Irmler, Horst, Dr. rer. nat.
Am Michelsgrund 20
D-6940 Weinheim(DE)

(72) Erfinder: Tursky, Werner, Dr. Dipl.-Ing.
Motterstrasse 42
D-8500 Nürnberg 60(DE)

(72) Erfinder: Grube, Reinhard, Dr. rer. nat.
Tuchergartenstrasse 29
D-8500 Nürnberg 10(DE)

(54) Rückwärts nicht sperrender Thyristor.

(57) Bei einem Thyristor, der zur Verkürzung der Freiwerdezeit eine gegenüber üblichen Thyristoren höherohmige und dünnere Mittelzone des ersten Leitungstyps und daran angrenzend eine hochdotierte, erste Basiszone gleichen Leitungstyps aufweist, die mit der anodenseitigen Emitterzone einen pn-Übergang bildet, ist die Freiwerdezeit noch weiter dadurch verkürzt, daß die anodenseitige Emitterzone mit Durchbrüchen zum Durchgriff der ersten Basiszone an die Oberfläche versehen ist, daß die erste Basiszone eine Dotierungskonzentration von $0,5 \times 10^{16}$ bis $1 \times 10^{18}/cm^3$ aufweist, und daß zum Beseitigen von Restladungen eine Hilfsthyristorzone mit einem Leitungsanschluß für eine negative Steuerspannung versehen oder über eine Diode mit der Steuerelektrode verbunden ist. Die erste Basiszone kann die anodenseitige Emitterzone ganz umschließen und Teil einer diese Emitterzone umfassenden Transistor-Schichtendolge sein.

Fig1

-1-

# RÜCKWÄRTS NICHT SPERRENDER THYRISTOR MIT KURZER

## FREIWERDEZEIT

Die Erfindung betrifft einen rückwärts nicht sperrenden Thyristor mit kurzer Freiwerdezeit, dessen Halbleiterkörper aus einer hochohmigen Mittelzone, einer an der einen Seite angrenzenden, höher dotierten Anodenbasiszone vom gleichen Leitungstyp und einer an der anderen Seite angrenzenden, höher dotierten Kathodenbasiszone vom entgegengesetzten Leitungstyp sowie aus einer an die Anodenbasiszone angrenzenden Anodenemitterzone und einer an die Kathodenbasiszone angrenzenden Kathodenemitterzone mit jeweils zwischenliegendem pn-Übergang besteht und an den Emitterzonen je eine Laststromelektrode sowie in der Kathodenbasiszone eine Steuerzone und eine Steuerstromelektrode aufweist.

Übliche Thyristoren mit einer Folge von vier schichtförmigen Zonen abwechselnd entgegengesetzten Leitungstyps haben in der Regel hohe Freiwerdezeiten. Zur Erzielung einer kürzeren Freiwerdezeit ist es bekannt, Gold oder Platin in den Halbleiterkörper

- 2 -

einzudiffundieren, wodurch die Rekombination der Ladungsträger nach der Durchlaßphase beschleunigt wird. Bei gegebener Sperrspannung sind damit jedoch die Nachteile eines höheren Durchlaßspannungsabfalls und einer Verschlechterung der Zündausbreitung verbunden.

Als günstigere Lösung zur Verkürzung der Freiwerdezeit ist der sogenannte rückwärts nicht sperrende Thyristor bekannt, der in der angelsächsischen Literatur in der Regel als asymmetrischer Thyristor bezeichnet ist ( ASCR ). Die Mittelzone seines Halbleiterkörpers ist gegenüber üblichen Thyristoren höherohmig und dünner und grenzt an eine hochdotierte, erste Basiszone gleichen Leitungstyps an. Die Letztere bildet mit der anodenseitigen Emitterzone einen pn-Übergang. Der höhere spezifische Widerstand der Mittelzone läßt eine höhere Sperrfähigkeit zu, jedoch kann sich die Raumladungszone, die bei anliegender Sperrspannung in Durchlaßrichtung in die Anodenbasiszone eindringt, in dieser wegen deren hoher Störstellenkonzentration nur sehr begrenzt ausdehnen. Andererseits ist die Sperrfähigkeit in Sperrichtung infolge der hohen Dotierung der Anodenbasiszone relativ gering, und ein Thyristor mit dieser Struktur sperrt im wesentlichen lediglich in Durchlaßrichtung.

Eine andere bekannte Lösung zur Verringerung der Freiwerdezeit stellt der sogenannte "gate-assistedturn-off-Thyristor" dar, bei dem zwischen Steuerelektrode und Kathodenemitterzone eine negative Spannung liegt. Damit soll erreicht werden, daß im

-3-

Bereich der Steuerelektrode das du/dt-Verhalten des Thyristors verbessert wird. Die negative Steuerspannung wirkt somit in diesem Bereich in gleicher Weise wie die sogenannten Emitterkurzschlüsse im Bereich der Emitterfläche. Außerdem werden durch die negative Steuerspannung Restladungen im Bereich der Steuerelektrode zur Steuerelektrode hin abgesaugt, wenn die negative Steuerspannung nach dem sogenannten Abkommutieren des Thyristors angelegt wird. Aufgrund bekannter physikalischer Zusammenhänge kann die negative Steuerspannung nur in einem relativ kleinen Bereich um die Steuerelektrode wirksam werden. Insbesondere bei Bauformen mit kathodenseitigen Emitterkurzschlüssen wird die negative Steuerspannung durch diese Kurzschlüsse in ihrer Wirkung erheblich beeinträchtigt. Wird jedoch auf solche Emitterkurzschlüsse verzichtet, so wird zwar die negative Steuerspannung voll wirksam, aber es besteht bei einem derartigen Thyristor wegen seines ungenügenden du/dt-Verhaltens die Gefahr des ungesteuerten Durchzündens.

Der Erfindung liegt die Aufgabe zugrunde, einen Thyristor anzugeben, welcher gegenüber bekannten Bauformen eine wesentlich reduzierte Freiwerdezeit aufweist. Die Lösung dieser Aufgabe besteht bei einem Thyristor der eingangs erwähnten Art darin, daß die Anodenemitterzone Durchbrüche zum Durchtritt der Anodenbasiszone an die Oberfläche enthält, daß die Dotierungskonzentration der Anodenbasiszone $0,5 \times 10^{16}$ pro $cm^3$ bis $1 \times 10^{18}$ pro $cm^3$ beträgt, und daß zur Verkürzung der Freiwerdezeit Mittel zum Beseitigen von Restladungen in der Kathodenbasiszone vorgesehen sind.

- 4 -

Vorteilhafte Ausgestaltungen der Erfindung sind Gegenstand der Ansprüche 2 bis 5.

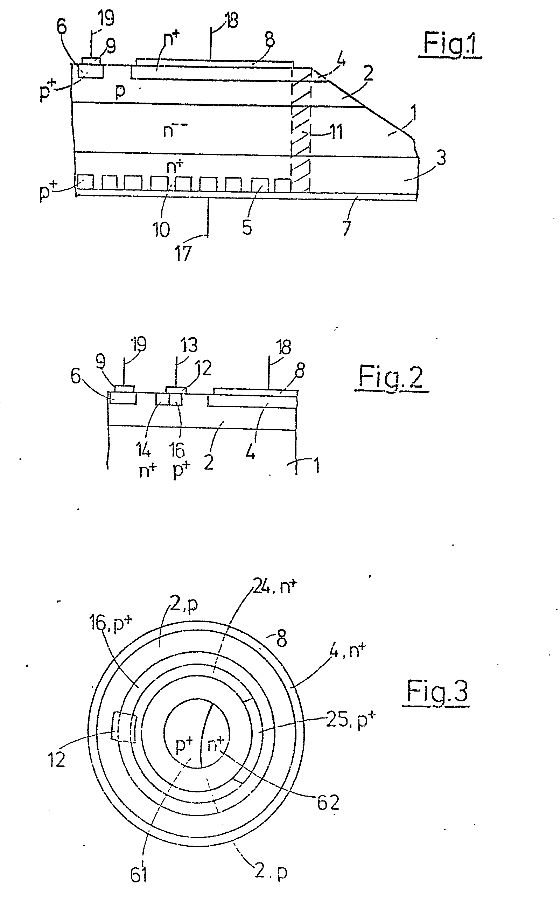

Anhand der in den Figuren 1 bis 3 dargestellten Ausführungsbeispiele wird der Gegenstand der Erfindung aufgezeigt und erläutert. In Figur 1 ist schematisch im Querschnitt die Schichtenfolge eines rückwärts nicht sperrenden Thyristors mit anodenseitigen Emitterkurzschlüssen dargestellt, Figur 2 zeigt im Ausschnitt eines Schemas nach Figur 1 eine Ausführungsform mit Hilfsthyristorzone, und in Figur 3 ist in Draufsicht auf eine kreisringförmige Schichtenstruktur schematisch die besondere Ausbildung der Steuerzone sowie der Hilfsthyristorzone und ihre gegenseitige Zuordnung gezeigt. Für gleiche Teile sind in allen Figuren gleiche Bezeichnungen gewählt.

Ein Halbleiterkörper gemäß Figur 1 bestehe aus einer hochohmigen, beispielsweise n-leitenden Mittelzone 1. Dafür kann Ausgangsmaterial mit einem spezifischen Widerstand im Bereich von 80 bis 200 $\Omega$cm gewählt sein. An die Mittelzone 1 schließt sich die hochdotierte Anodenbasiszone 3 - weiterhin als n-Basis bezeichnet - vom gleichen Leitungstyp an, und auf der anderen Seite der Mittelzone 1 ist die ebenfalls höher dotierte Kathodenbasiszone 2 - weiterhin als p-Basis bezeichnet - vom anderen Leitungstyp angeordnet. In die n-Basis 3 ist die hochdotierte, p-leitende Anodenemitterzone 5 eingebracht, in welcher die sogenannten Anodenkurzschlüsse 10 vorgesehen sind. Andererseits ist die p-Basis 2 noch mit der $n^+$-leitenden Kathodenemitterzone 4 versehen und weist außer-

-5-

dem die hochdotierte Steuerzone 6 auf. Auf beiden Emitterzonen (4,5) sind die Laststromelektroden 7 bzw. 8
und auf der Steuerzone 6 ist die Steuerelektrode 9 aufgebracht. Die Anodenkurzschlüsse haben dieselbe Wirkung
wie die bei der Kathodenemitterzone bekannten Emitterkurzschlüsse. Das heißt der entsprechende Teiltransistor des Thyristoraufbaus ist durch diese Kurzschlüsse
in seiner Stromverstärkung unwirksam. Dabei ist von
Bedeutung, daß die Abstände der Kurzschlüsse nicht
zu groß sind. Zu diesem Zweck soll auch die Querleitfähigkeit in der an die kurzgeschlossene Anodenemitterzone angrenzenden Basiszone entsprechend hoch
sein. Eine solche Querleitfähigkeit ist erfindungsgemäß in der hochdotierten Anodenbasiszone 3 mit
einer Konzentration im Bereich von $0,5 \times 10^{16}$ bis
$1 \times 10^{18}$ pro $cm^3$ gegeben. Aufgrund der Anodenkurzschlüsse weist ein solcher Schichtenaufbau auch ein
gewünschtes du/dt-Verhalten auf, und bei Anlegen einer negativen Steuerspannung besteht nicht der Nachteil, daß dieselbe in ihrer Ausbreitung unter die
Kathodenemitterzone 4 beeinträchtigt wird.

Erfindungsgemäß ist in dem beschriebenen Schichtenaufbau auch ein sogenannter Anodenkurzschlußring
vorgesehen. Das heißt die hochdotierte Anodenbasiszone 3 umschließt die Anodenemitterzone 5 gegebenenfalls unter Berücksichtigung einer in der Figur dargestellten Abschrägung der Randzone in einem solchen Abstand von der Mantelfläche des Halbleiterkörpers, daß im wesentlichen nur noch eine Folge
aus drei Zonen abwechselnd entgegengesetzten Leitungstyps, d.h. eine Transistorstruktur, gegeben ist.

Dadurch wird die Verstärkung eines im Randbereich anfallenden Sperrstromes durch den aus den Zonen 5, 3 und 1/2 bestehenden Transistors verhindert.

Bei größeren Thyristoranordnungen ist es üblich, eine allgemein als amplifying-gate bezeichnete Hilfsthyristorzone zu verwenden und darüberhinaus Steuerelektrodenstrukturen einzubauen, welche die Emitterzone fingerförmig durchdringen. In Figur 2 ist schematisch ein Ausschnitt einer Anordnung mit Hilfsthyristorzone dargestellt. In der Kathodenbasiszone 2 ist zwischen der Steuerzone 6 und der Kathodenemitterzone 4 im Abstand zur Steuerzone 6 eine hochdotierte, ebenfalls an die Oberfläche grenzende, jedoch anderen Leitungstyp aufweisende Zone 14 und daran angrenzend unter Bildung eines pn-Übergangs eine hochdotierte Zone 16 angeordnet. Beide sind durch eine Metallisierung 12 in der Weise kontaktiert, daß der zwischen den Zonen 14 und 16 befindliche pn-Übergang durch die Kontaktierung 12 kurzgeschlossen ist, und daß außerdem über diese Kontaktierung eine ohmische Verbindung zwischen der Zone 14 und zwischen dem an die Oberfläche reichenden Bereich der Kathodenbasiszone 2 hergestellt ist, welcher zwischen der Kathodenemitterzone 4 und der Hilfsthyristorzone liegt.

Bei üblichen Thyristoren mit Hilfsthyristorzone weisen lediglich die Kathodenemitterelektrode und die Steuerelektrode jeweils einen Leitungsanschluß auf (18 bzw. 19 ). Der Zündmechanismus solcher Anordnungen ist bekannt und nicht Gegenstand der Erfindung. Das Durchschalten erfolgt zunächst mit Hilfe eines Zündimpulses in dem durch die beiden Zonen 14 und 16 bestimmten Volumenbereich des Halbleiterkörpers, der einen Hilfsthyristor bildet, und anschließend zündet der Hauptthyristor längs des ganzen Verlaufs der Hilfsthyristorzone (14/16).

Um die Vorteile einer negativen Steuerspannung auch bei einer solchen Thyristoranordnung nutzen zu können, muß die Hilfsthyristorzone mit einer solchen Spannung beaufschlagt werden. Erfindungsgemäß weist daher die Metallisierung 12 der Hilfsthyristorzone einen Leitungsanschluß 13 auf, welcher mithilfe einer weiteren Durchführung durch das nicht dargestellte Gehäuse geführt ist. Damit ist es möglich, Restladungen der Kathodenemitterzone 4 im Bereich der Hilfsthyristorzone auszuräumen.

Weiter ist es bekannt, zur Beseitigung von Restladungen zwischen der Steuerelektrode und Hilfsthyristorzone eine Diode anzuordnen. Dann kann der zusätzliche Leitungsanschluß 13 entfallen. Ein solches Schaltungselement ist auch beim Gegenstand der Erfindung vorteilhaft anwendbar. Insbesondere ist erfindungsgemäß eine solche Diode im Halbleiterkörper der Thyristorstruktur integriert angebracht. In Figur 3 ist, beschränkt auf den Bereich von Steuerzone, Hilfsthyristorzone und Randabschnitt der Kathodenemitterzone, schematisch in Draufsicht eine solche Struktur dargestellt. Die Steuerzone, welche in den vorangehend beschriebenen Ausführungsbeispielen einen hochdotierten Volumenabschnitt der Kathodenbasiszone 2 darstellt, ist erfindungsgemäß unterteilt in einen $p^+$-leitenden Abschnitt 61 und in einen $n^+$-leitenden Abschnitt 62. Aufgrund der zentralen Anordnung der Steuerzone ist die aus den Teilzonen 24 und 16 bestehende Hilfsthyristorzone ringförmig um die Steuerzone ausgebildet. Von der, der Steuerzone benachbarten, $n^+$-leitenden Zone 24 ist das dem $n^+$-leitenden Abschnitt 62 der Steuerzone gegenüberliegende Ringsegment 25 entgegengesetzt dotiert, wodurch parallel zur Schichtenebene aus dem Abschnitt 62 der Steuerzone, aus dem angrenzenden Volumenabschnitt der Kathodenbasiszone 2 und aus dem Segment 25 der Hilfsthyristor-Teilzone 24 eine Zonenfolge gebildet ist, die als psn-Diode mit Stromflußrichtung von der Hilfsthyristorzone zur Steuerzone wirkt. Dabei ist der Abschnitt 62 der Steuerzone in seiner räumlichen Ausdehnung gegenüber dem Segment 25 der Hilfsthyristorzone so bemessen, daß ein unerwünschter Leckstrom zwischen dem Abschnitt 61 der Steuerzone und dem Segment 25 der Hilfsthyristorzone verhindert wird.

Die Wirksamkeit der Steuerzone wird durch die Unterteilung in einen p-leitenden und in einen n-leitenden Abschnitt nicht herabgesetzt, weil es zur Funktion der Hilfsthyristorzone ausreicht, daß lediglich z.B. die Hälfte ihrer Flächenausdehnung gezündet wird. Beim Durchschalten des Hauptthyristors wird dann die gesamte Ringfläche der Hilfsthyristorzone gezündet.

Mit einem Schichtenaufbau gemäß der Erfindung wird die Freiwerdezeit bei Thyristoren beträchtlich reduziert. Weisen beispielsweise übliche Thyristoren bei einer Sperrspannung von etwa 1200 Volt eine Freiwerdezeit von 20 /usec. auf und kann weiterhin beim bekannten Aufbau eines rückwärts nicht sperrenden

- 9 -

Thyristors ( ASCR ) die Freiwerdezeit auf die Hälfte reduziert werden, so ist es möglich, mit Hilfe einer negativen Spannung mit anodenseitigen Emitterkurzschlüssen und unter Verzicht auf kathodenseitige Emitterkurzschlüsse die Freiwerdezeit noch weiter etwa um den Faktor 4 zu reduzieren. Mit Hilfe der anodenseitigen Emitterkurzschlüsse wird dabei das du/dt- Verhalten im wesentlichen nicht verschlechtert.

Bei der Herstellung eines Halbleiterkörpers gemäß der Erfindung wird zunächst in hochohmigem Ausgangsmaterial eines Leitungstyps, beispielsweise in einer n-leitenden Siliziumscheibe, auf jeder Seite je eine höher dotierte Zone entgegengesetzten Leitungstyps erzeugt. In weiteren Verfahrensschritten wird die eine der beiden p-leitenden Zonen bis zum Ausgangsmaterial abgetragen und in demselben eine höher dotierte Zone vom Leitungstyp des Ausgangsmaterials hergestellt. Damit liegt eine $p^+n^-n^+$-Struktur vor, d.h. ein Aufbau aus einer hochohmigen Mittelzone, einer Anodenbasiszone vom gleichen Leitungstyp und einer Kathodenbasiszone vom entgegengesetzten Leitungstyp. Daran anschließend werden durch getrennte Diffusionsprozesse, teilweise mithilfe der Maskentechnik, sowohl die $n^+$-leitende Kathodenemitterzone 4 als auch die $p^+$-leitende Anodenemitterzone 5 mit Anodenkurzschlüssen 10 hergestellt. Gleichzeitig mit der Anodenemitterzone 5 kann auch die hochdotierte Steuerzone 6 erzeugt werden.

Im Falle von Strukturen gemäß den Figuren 2 bzw. 3 werden gleichzeitig mit der Herstellung der Kathodenemitterzone 4 auch die $n^+$-leitenden Teilzonen der Steuerzone (62) und der Hilfsthyristorzone (14 bzw. 24 ) erzeugt. Ferner werden gleichzeitig mit der Anodenemitterzone 5 auch sämtliche $p^+$-leitenden Abschnitte der Steuerzone (61) und der Hilfsthyristorzone (25 bzw. 16 ) hergestellt.

Derartige Schichtenfolgen werden danach mit ihren Kontaktelektroden (7,8,9,12) versehen, wobei die Metallisierung 12 der Hilfsthyristorzone in Figur 3 lediglich zu einem kleinen Teil ihrer gesamten Flächenausdehnung dargestellt ist.

PATENTANSPRÜCHE

1. Rückwärts nicht sperrender Thyristor mit kurzer Freiwerdezeit, dessen Halbleiterkörper aus einer hochohmigen Mittelzone, einer an der einen Seite angrenzenden, höher dotierten Anodenbasiszone vom gleichen Leitungstyp und einer an der anderen Seite angrenzenden, höher dotierten Kathodenbasiszone vom entgegengesetzten Leitungstyp sowie aus einer an die Anodenbasiszone angrenzenden Anodenemitterzone und einer an die Kathodenbasiszone angrenzenden Kathodenemitterzone mit jeweils zwischenliegendem pn-Übergang besteht und an den Emitterzonen je eine Laststromelektrode sowie in der Kathodenbasiszone eine Steuerzone und eine Steuerstromelektrode aufweist, d a d u r c h ,  g e k e n n z e i c h n e t,

daß die Anodenemitterzone (5) Durchbrüche (10) zum Durchtritt der Anodenbasiszone (3) an die Oberfläche enthält,

daß die Dotierungskonzentration der Anodenbasiszone (3) $0,5 \times 10^{16}$ pro $cm^3$ bis $1 \times 10^{18}$ pro $cm^3$ beträgt, und

daß zur Verkürzung der Freiwerdezeit Mittel zum Beseitigen von Restladungen in der Kathodenbasiszone (2) vorgesehen sind.

2. Rückwärts nicht sperrender Thyristor nach Anspruch 1, dadurch gekennzeichnet, daß im Randbereich des Halbleiterkörpers die Anodenbasiszone (3) die Anodenemitterzone (5) vollständig umschließt und mit dieser die eine Hauptfläche bildet, und daß der die Anodenemitterzone (5) umfassende Volumenabschnitt (11) eine Transistorschichtenfolge aufweist.

3. Rückwärts nicht sperrender Thyristor nach Anspruch 1 oder 2, dadurch gekennzeichnet, daß zwischen der die Steuerzone (6) kontaktierenden Steuerelektrode (9) und der Kathodenemitterzone (4) eine Hilfsthyristorzone (14, 16) mit Kontaktüberzug (12) vorgesehen ist, und daß zum Beseitigen von Restladungen durch Anlegen einer negativen Steuerspannung an die Hilfsthyristorzone (14, 16) diese einen Leitungsanschluß (13) aufweist, der durch das Gehäuse nach außen gelegt ist.

4. Rückwärts nicht sperrender Thyristor nach Anspruch 1 oder 2, dadurch gekennzeichnet, daß zwischen der die Steuerzone (6) kontaktierenden Steuerelektrode (9) und der Kathodenemitterzone (4) eine Hilfsthyristorzone (14,16) mit Kontaktüberzug (12) vorgesehen ist, und daß zum Beseitigen von Restladungen durch Anlegen einer negativen Steuerspannung an die Steuerelektrode (9) zwischen Steuerelektrode (9) und Kontaktüberzug (12) eine Diode (D) angeordnet ist.

5. Rückwärts nicht sperrender Thyristor nach Anspruch 4, dadurch gekennzeichnet, daß die Diode im Halbleiterkörper integriert angeordnet ist, und daß die integrierte Diode aus dem einen Bereich (62) der aus zwei Bereichen (61,62) mit zwischenliegendem pn-Übergang bestehenden Steuerzone, aus einem diesem Bereich gegenüberliegenden Abschnitt (25) der benachbarten (14) der beiden Teilzonen der Hilfsthyristorzone, mit zum übrigen Abschnitt dieser Teilzone entgegengesetzten Leitungstyp, sowie aus dem zwischenliegenden Volumenabschnitt der zugeordneten Basiszone (2)
gebildet ist.

1|1

Fig.1

Fig.2

Fig.3

Europäisches Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y | EP-A-0 014 098 (HITACHI) <br> * Ansprüche 1-10 * <br><br> --- | 1,3,4 | H 01 L 29/08 <br> H 01 L 29/10 <br> H 01 L 29/743 |
| Y | FR-A-2 428 918 (GENERAL ELECTRIC CY.) <br> * Seite 17, Zeile 15 - Seite 8, Zeile 19; Figur 1 * <br><br> --- | 1,2 | |
| Y | DE-A-2 906 721 (HITACHI) <br> * Anspruch 1; Figur 6 * <br><br> --- | 1,3 | |
| A | DE-A-2 500 384 (MITSUBISHI DENKI K.K.) <br> * Anspruch 1 * <br><br> ----- | 4,5 | |

RECHERCHIERTE SACHGEBIETE (Int. Cl. ³)

H 01 L

Der vorliegende Recherchenbericht wurde für alle Patentansprüche erstellt.

| Recherchenort | Abschlußdatum der Recherche | Prüfer |
|---|---|---|
| DEN HAAG | 01-07-1982 | VANCRAEYNEST F.H. |